Europäisches Patentamt

European Patent Office

Office européen des brevets

(19)

(11) Veröffentlichungsnummer: **0 270 844**
**B1**

(12) **EUROPÄISCHE PATENTSCHRIFT**

(45) Veröffentlichungstag der Patentschrift:
05.09.90

(21) Anmeldenummer: 87116352.3

(22) Anmeldetag: 05.11.87

(51) Int. Cl.⁵: **H05K 7/14**

(54) Gehäuse, insbesondere eine Einsatzbaugruppe zur Aufnahme von Leiterplatten.

(30) Priorität: 18.11.86 DE 3639404

(43) Veröffentlichungstag der Anmeldung:
15.06.88 Patentblatt 88/24

(45) Bekanntmachung des Hinweises auf die Patenterteilung:
05.09.90 Patentblatt 90/36

(84) Benannte Vertragsstaaten:
AT BE CH DE FR GB IT LI SE

(56) Entgegenhaltungen:
EP-A- 0 109 569
DE-B- 1 490 469
GB-A- 1 081 526

(73) Patentinhaber: Siemens Aktiengesellschaft,
Wittelsbacherplatz 2, D-8000 München 2(DE)

(72) Erfinder: Assel, Eugen, Dipl.-Ing., Hauptstrasse 6,
D-8729 Knetzgau(DE)
Erfinder: Dasbach, Burkhard, Dipl.-Ing.,
Kastanienweg 39, D-8520 Erlangen(DE)

## Beschreibung

Die Erfindung bezieht sich auf ein Gehäuse, insbesondere eine Einsatzbaugruppe zur Aufnahme von Leiterplatten, bestehend aus zwei Profilen, die jeweils mit zwei an gegenüberliegenden Randbereichen angeordneten Aufnahmen versehen sind, Abdeckbleche und einer Front-und einer Rückplatte.

Ein derartiges Gehäuse ist im Handel erhältlich und ist unter der Bezeichnung "Kassette" bekannt. Die Basis dieser Kassette bilden zwei stabile Aluminium-Seitenprofile mit Aufnahmen für das obere und untere Deckblech. Die Deckbleche sind aus gelochtem Stahlblech. Die Front- und Rückplatte sind aus Aluminium gefertigt und an den Profilen befestigt. Die Aufnahme für das obere und untere Deckblech ist derartig gestaltet, daß die Deckbleche in einer Nut geführt und von einer Auflage abgestützt werden. Mit diesen Auflagen ist jedes Deckblech verschraubt. Außerdem sind diese Aufnahmen der Seitenprofile an den Stirnseiten jeweils mit Bohrungen versehen, damit die Front- und die Rückplatte lösbar mit Schrauben befestigt werden kann.

Der Erfindung liegt nun die Aufgabe zugrunde, ein Gehäuse der eingangs genannten Art so weiterzubilden, daß keine lösbaren Verbindungsmittel für eine lösbare Verbindung korrespondierender Profile vorgesehen sind.

Diese Aufgabe wird erfindungsgemäß dadurch gelöst, daß jede Aufnahme als federnde Hohlkehle ausgebildet ist und daß als Abdeckbleche jeweils ein Profil vorgesehen ist, dessen zwei gegenüberliegende Randbereiche jeweils derart zu einem zylinderförmigen zur federnden Hohlkehle korrespondierenden Auge gestaltet ist, daß im eingeschnappten Zustand von Auge und Hohlkehle die korrespondierenden Profile rechtwinklig zueinander angeordnet sind.

Durch diese Schnappverbindung von jeweils zwei korrespondierenden Profilen besteht das Gehäuse aus vier Walzprofilen, von denen je zwei Profile die gleiche Profilform aufweisen. Dadurch benötigt man nur ein Werkzeug pro Profilform mit dem man alle möglichen Breiten- und Höhenabmessungen erstellen kann. Dieses zusammengesetzte Gehäuse ist mit dieser Kantenverbindung selbsttragend und somit unabhängig von einer Front- und Rückplatte. Die Front- und Rückplatte kann aber durch die Gestaltung der Profile mittels selbstfurchender Schrauben direkt an der Gehäuse-Kantenverbindung befestigt werden. Zum Verbinden zweier Profile benötigt man keine zusätzlichen Verbindungsmittel und Werkzeuge, wodurch man aus einzelnen Profilen ein Gehäuse schnell und einfach aufbauen kann. Außerdem besteht die Möglichkeit, die Profile für ein Gehäuse am laufenden Meter herzustellen und zu einem quaderförmigen Rohr zusammenzusetzen. Von diesem quaderförmigen Rohr können dann die einzelnen Gehäuse mit ihren vorbestimmten Gehäusetiefen abgetrennt werden.

In einer vorteilhaften Ausführungsform des Gehäuses sind jeweils zwei Profile mit zu den Führungsleisten eines Baugruppenträgers korrespondierenden Stegen versehen. Dadurch besteht die Möglichkeit, ein aus diesen Profilen aufgebautes Gehäuse wie eine Steckbaugruppe in einen Baugruppenträger einzuführen. Dabei kann der Steg Bestandteil des Seitenprofils oder des Abdeckprofils sein.

In einer weiteren vorteilhaften Ausführungsform des Gehäuses ist das freie Ende des zylinderförmigen Auges durch die Profilgestaltung von Teilen eines Profils umklammert. Durch diese Ausgestaltung wird zusätzlich verhindert, daß beim Einschrauben von Befestigungsschrauben für die Front- und Rückplatte das Kernloch des zylinderförmigen Auges aufgeweitet wird.

Zur weiteren Erläuterung der Erfindung wird auf die Zeichnung Bezug genommen, in der Ausführungsbeispiele nach der Erfindung schematisch veranschaulicht sind.

FIG 1 zeigt ein Gehäuse nach der Erfindung eingeschoben in einen Baugruppenträger, in

FIG 2 ist eine Kantenverbindung zweier korrespondierender Profile des Gehäuses nach FIG 1 dargestellt, die

FIG 3 zeigt eine weitere Ausgestaltung zweier korrespondierender Profile im eingeschnappten Zustand, in

FIG 4 ist eine Seitenansicht des Gehäuses nach FIG 1 in einem Baugruppenträger dargestellt und die

FIG 5 bis 7 zeigen weitere Ausführungen zweier Profile im eingeschnappten Zustand.

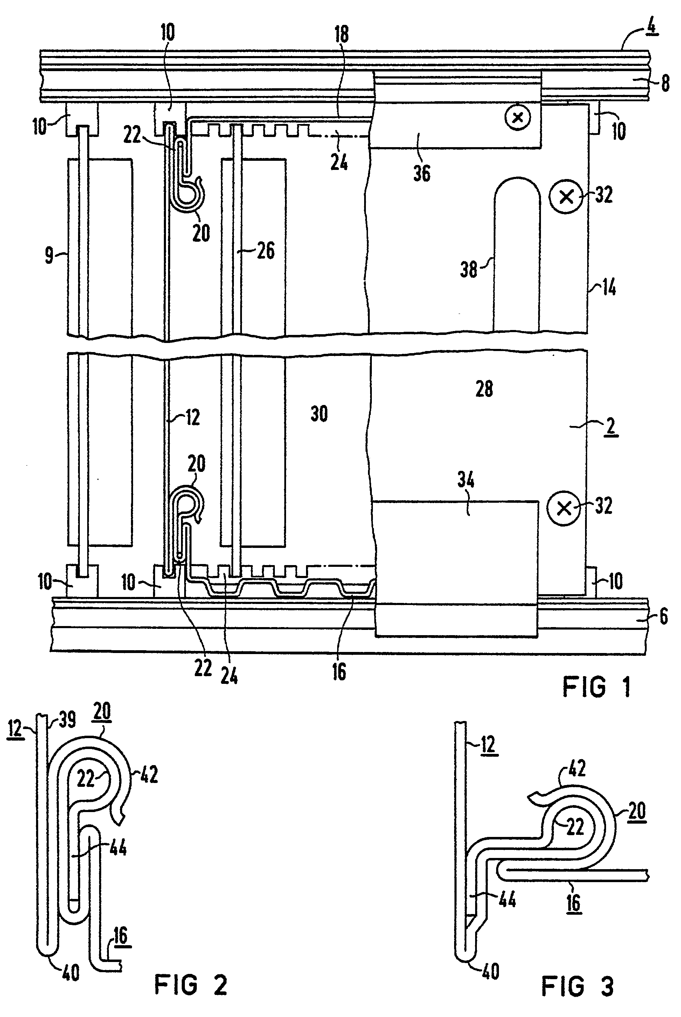

Die FIG 1 zeigt ein Gehäuse 2 in einem Baugruppenträger 4, wobei vom Baugruppenträger 4 nur die vorderen Querschienen 6 und 8 mit jeweils drei Führungsschienen 10 dargestellt sind. Dabei wird das Gehäuse 2 oben und unten jeweils von zwei Führungsschienen 10 im Baugruppenträger 4 geführt. In den auf der linken Seite neben dem Gehäuse 2 im Baugruppenträger 4 gezeigten Steckplatz ist eine Steckbaugruppe 9 gesteckt. Das Gehäuse 2 besteht aus zwei Seitenprofilen 12 und 14 und zwei Deckprofilen 16 und 18. Jeweils zwei gegenüberliegende Randbereiche der Seitenprofile 12 und 14 sind mit Aufnahmen 20 versehen, die als federnde Hohlkehlen ausgebildet sind. Die gegenüberliegenden Randbereiche der korrespondierenden Deckprofile 16 und 18 sind jeweils zu einem zylinderförmigen Auge 22 geformt, die jeweils von der federnden Hohlkehle aufgenommen sind. Außerdem ist das Deckprofil 18 perforiert und das Deckprofil 16 mit Kühlrippen versehen. Ferner enthält das Gehäuse 2 mehrere Querschienen 24, die jeweils mehrere nebeneinander angeordnete Nuten enthalten, so daß Steckbaugruppen 26 im Gehäuse 2 geführt werden können. Dadurch bietet das Gehäuse 2 die Möglichkeit mehrere Steckbaugruppen 26 als Funktionsblock zusammenzufassen. Das Gehäuse 2 ist ferner mit einer Front- und Rückplatte 28 und 30 versehen, die jeweils mit selbstfurchenden Schrauben 32 an den Kantenverbindungen zweier Profile befestigt sind. Durch die allseits geschlossene Bauform werden die Steckbaugruppen 26 gegen hochfrequente Strahlung abgeschirmt. Die Frontplatte 28 ist außerdem mit einer Steck- und Ziehhilfe 34, die in die untere, vordere Querschiene 6 des Baugruppenträgers 4 eingreift, und mit einer Verriegelungsfeder 36 versehen. Die Verriegelungsfeder 36 greift in die obere, vordere Querschiene 8 des Baugruppenträgers 4 ein und verhindert ein unbeabsichtigtes Herausziehen des Gehäuses 2. Bei leichten Gehäusen 2 genügt zum Stecken und Ziehen des Gehäuses 2 in den Baugruppenträger 4 die Steck- und Ziehhilfe 34. Größere und schwerere Gehäuse 2, insbesondere Einsatzbaugruppen, werden mit Hilfe von Bügelgriffen 38 in den Baugruppenträger 4 gesteckt und herausgezogen. Zum Verriegeln dieser schweren Gehäuse 2 dient die Verriegelungsfeder 36.

In FIG 2 ist eine Kantenverbindung zweier korrespondierender Profile 12 und 16 des Gehäuses 2 dargestellt. Der Randbereich des Profils 12 ist um 180° zur vorbestimmten Innenseite 39 des Gehäuses 2 gebogen. Dabei bildet die entstandene gebogene Kante einen Steg 40, wodurch das Gehäuse 2 in den Führungsschienen 10 des Baugruppenträgers 4 geführt werden kann. Das freie Ende 42 des Randbereichs des Profils 12 ist zu einer Aufnahme 20 in Form einer Hohlkehle geformt, die in Richtung des Stegs 40 offen ist. Der Randbereich des Profils 16 ist zu einem zylinderförmigen zur federnden Hohlkehle korrespondierenden Auge 22 gestaltet, wobei das freie Ende 44 des zylinderförmigen Auges 22 von Teilen des Profiles 16 umklammert ist. Im eingeschnappten oder eingezogenen Zustand umschließt die federnde Hohlkehle des Profils 12 das zylinderförmige Auge 22 des Profils 16, wodurch die beiden korrespondierenden Profile 12 und 16 rechtwinklig zueinander angeordnet sind.

Alle vier Kantenverbindungen des Gehäuses 2 sind derart gestaltet und zusammengesetzt, so daß das Gehäuse 2 selbsttragend ist. Dadurch weisen jeweils zwei Profile 12, 14 und 16, 18 die gleiche Profilform auf, wodurch jeweils nur ein Werkzeug pro Profilform benötigt wird, mit dem man alle möglichen Breiten- und Höhenabmessungen am laufenden Meter walzen kann. Die Walzprofile können aus Aluminium oder Stahl, wobei die Oberflächen verzinkt, pulver- oder kunststoffbeschichtet sind. Außerdem können die Profile aus Entwärmungsgründen beim Walzvorgang zusätzlich profiliert werden oder vor/nach dem Walzvorgang, zwecks Durchzugsbelüftung, gelocht werden. Die gewalzten Profile 12, 14, 16 und 18 können auf vorbestimmte Längen geschnitten und dann zu einem Gehäuse 2 zusammengefügt werden, oder die Profile 12, 14, 16 und 18 werden nach dem Walzen zu einem quaderförmigen Rohr zusammengefügt und dann auf vorbestimmte Gehäusetiefen geschnitten.

In der FIG 3 ist das freie Ende 42 des Randbereichs des Profils 16 zu einer Aufnahme 20 in Form einer federnden Hohlkehle gestaltet, wobei diese Hohlkehle in Richtung des Seitenprofils 12 geöffnet ist. Der Randbereich dieses Profils 12 ist zu einem Steg 40 und einem zylinderförmigen Auge 22 geformt, wobei das freie Ende 44 von Teilen des Steges 40 umschlossen ist. Auch bei dieser Ausführungsform umschließt die federnde Hohlkehle das zylinderförmige Auge 22. Durch das Einklemmen des freien Endes 44 des Auges 22 und durch das Umschließen des Auges 22 durch die Hohlkehle kann beim Einschrauben einer Schraube 32 in das Kernloch des Auges 22 dieses nicht aufgeweitet werden.

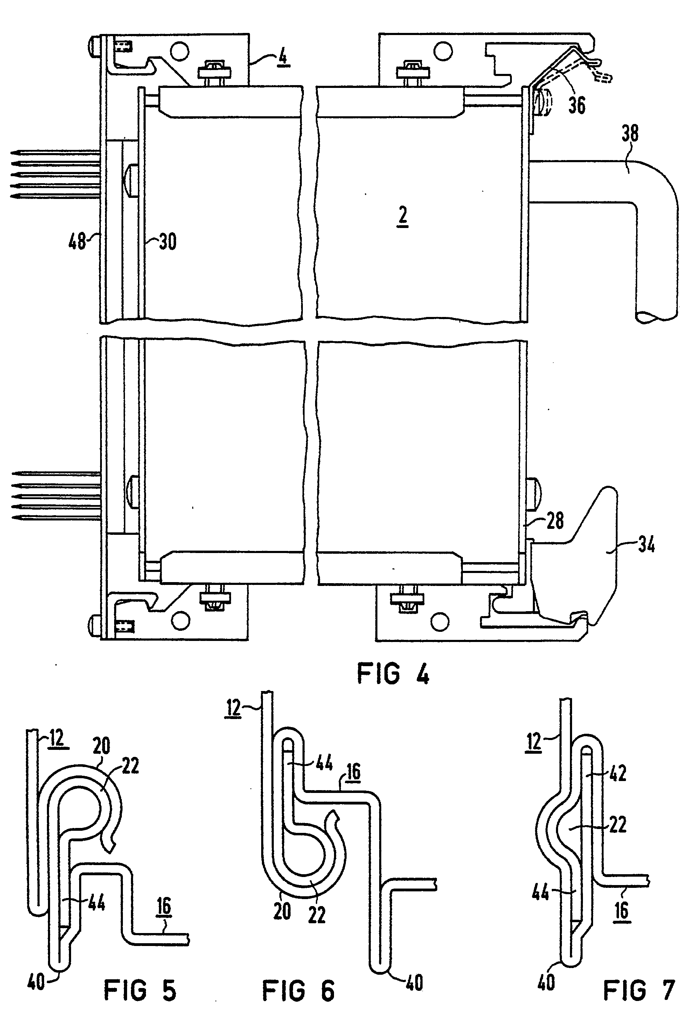

Die FIG 4 zeigt eine Seitenansicht des Gehäuses 2 im Baugruppenträger 4. Die externe elektrische Verbindung des Gehäuses 2 erfolgt über Steckverbinder 46, die an der Rückplatte 30 bzw. des Gehäuses 2 bzw. des Baugruppenträgers 4 angebracht sind. Als Rückplatte 30 kann auch eine Rückwand-Leiterplatte mit einem Steckverbinder 46 oder Anschlußpins verwendet werden.

Die FIG 5 und 6 zeigen weitere Ausgestaltungen der Randbereiche der Profile 12 und 16, wobei das Profil 12 jeweils mit einer als federnde Hohlkehle ausgebildeten Aufnahme 20 versehen ist. Dabei ist die Öffnung der Hohlkehle nach FIG 5 dem Steg 40 zugewandt und nach FIG 6 dem Steg 40 abgewandt. In beiden Figuren ist der Randbereich des Profils 16 zu einem zylinderförmigen zur federnden Hohlkehle korrespondierenden Auge 22 ausgestaltet, wobei das freie Ende 44 von Teilen des Profils 16 umklammert ist. Dabei bilden nach FIG 5 die Teile, die das freie Ende 40 umklammern, den Steg 40, wobei nach FIG 6 der Steg 40 extra aus dem Profil 16 geformt ist.

In FIG 7 ist eine einfache Ausgestaltung der Profile 12 und 16 dargestellt. Dabei ist der Randbereich des Profils 12 mit einer Hohlkehle versehen, deren freies Ende 42 den Steg 40 bildet und von Teilen des Profils 16 umklammert wird. Der Randbereich des Profils 16 ist zu einer zur federnden Hohlkehle des Profils 12 korrespondierenden Hohlkehle gestaltet, die zusammen mit dem umklammerten Ende 42 des Profils 12 ein zylinderförmiges Auge 22 bildet. Das freie Ende 44 ist von Teilen des Profils 12, die den Steg 40 bilden, umklammert. Dadurch erhält man einfach ausgebildete Profile 12 und 16, mit denen man schnell und einfach ein selbsttragendes Gehäuse 2 zusammenbauen kann ohne zusätzliche Verbindungsmittel oder Werkzeuge zu verwenden.

**Patentansprüche .**

1. Gehäuse (2), insbesondere eine Einsatzbaugruppe zur Aufnahme von Leiterplatten (26), bestehend aus zwei Profilen (12, 14), die jeweils mit zwei an gegenüberliegenden Randbereichen angeordneten Aufnahmen (20) versehen sind, Abdeckbleche und einer Front-und einer Rückplatte (28, 30), **dadurch gekennzeichnet**, daß jede Aufnahme (20) als federnde Hohlkehle ausgebildet ist und daß als Abdeckbleche jeweils ein Profil (16, 18) vorgesehen ist, dessen zwei gegenüberliegende Randbereiche jeweils derart zu einem zylinderförmigen zur federnden Hohlkehle korrespondierenden Auge (22) gestaltet ist, daß im eingeschnappten Zustand vom Auge (22) und Hohlkehle die korrespondierenden Profile (12, 16) rechtwinklig zueinander angeordnet sind.

2. Gehäuse (2) nach Anspruch 1, **dadurch gekennzeichnet**, daß jeweils zwei Profile (12, 14, 16, 18) mit zu Führungsleisten (10) eines Baugruppenträgers (4) korrespondierenden Stegen (40) versehen sind.

3. Gehäuse (2) nach Anspruch 1, **dadurch gekennzeichnet**, daß das freie Ende (44) des zylinderförmigen Auges (22) durch die Profilgestaltung von Teilen eines Profils (12, 16) umklammert ist.

4. Gehäuse (2) nach Anspruch 1, **dadurch gekennzeichnet**, daß die Front- und Rückplatte (28, 30) lösbar mittels der zylinderförmigen Augen (22) mit den Profilen (12, 14, 16, 18) verbunden sind.

## Claims

1. A housing (2), in particular a plug-in package to hold printed circuit boards (26), comprising two profiles (12, 14) which are each provided with two respective holding fixtures (20) arranged on opposite edge regions, cover plates and a front and a back panel (28, 30), characterised in that each holding fixture (20) is formed as a resilient channel and that each cover plate is a profile (16, 18) of which two opposite edge regions are formed into a cylindrical eye (22) corresponding to the resilient channel, such that when the eye (22) and channel are snap-locked together the corresponding profiles (12, 16) are arranged at right angles to one another.

2. A housing (2) according io claim 1, characterised in that two of the profiles (12, 14, 16, 18) are provided with ribs (40) corresponding to guide grooves (10) in a mounting rack (4).

3. A housing (2) according to claim 1, characterised in that the free end (44) of the cylindrical eye (22) is embraced by parts of a profile (12, 16) as a result of the construction of the profile.

4. A housing (2) according to claim 1, characterised in that the front and back panels (28, 30) are separably connected to the profiles (12, 14, 16, 18) by means of the cylindrical eyes (22).

## Revendications

1. Boîtier (2), notamment module enfichable destiné à loger des plaquettes à circuits imprimés (26), constitué par deux profilés (12, 14), qui sont pourvus respectivement de logements (20) disposés dans des zones marginales opposées, des tôles de revêtement et une plaque avant et une plaque arrière (28, 30), caractérisé par le fait que chaque logement (20) est réalisé sous la forme d'une gouttière élastique, et qu'il est prévu, comme tôles de revêtement, respectivement un profilé (16, 18), dont deux zones marginales opposées sont agencées respectivement pour former un œillet cylindrique (22) correspondant à la gouttière élastique, de sorte que, lorsque l'œillet (22) et la gouttière sont à l'état encliqueté, les profilés correspondants (12, 16) sont perpendiculaires entre eux.

2. Boîtier (2) suivant la revendication 1, caractérisé par le fait que respectivement deux profilés (12, 14, 16, 18) sont pourvus de barrettes (40), qui correspondent à des barrettes de guidage (10) d'un porte-modules (4).

3. Boîtier (2) suivant la revendication 1, caractérisé par le fait que l'extrémité libre (44) de l'œillet cylindrique (22) est serrée, par la configuration profilée de parties d'un profilé (12, 16).

4. Boîtier (2) suivant la revendication 1, caractérisé par le fait que la plaque avant et la plaque arrière (28, 30) sont réunies de façon amovible, au moyen des œillets cylindriques (22), aux profilés (12, 14, 16, 18).

FIG 1

FIG 2

FIG 3

FIG 4

FIG 5

FIG 6

FIG 7